# EUROPÄISCHE PATENTSCHRIFT

(11) **EP 2 851 941 B1**
(45) Veröffentlichungstag und Bekanntmachung des Hinweises auf die Patenterteilung: **07.09.2016**
(21) Anmeldenummer: 13185634.6
(22) Anmeldetag: 23.09.2013
(51) Int. Cl.: H01L 21/683

(54) **Verfahren zur Übergabe eines gedünnten, insbesondere geschliffenen, Halbleiterwafers**
Method for transferring a thinned, in particular ground, semiconductor wafer
Procédé de transfert d'une tranche semi-conductrice amincie, notamment polie

(43) Veröffentlichungstag der Anmeldung: 25.03.2015
(73) Patentinhaber: Mechatronic Systemtechnik GmbH, 9500 Villach (AT)
(72) Erfinder: Schober, Walter, 9232 St. Martin/Rosegg (AT)
(74) Vertreter: Jell, Friedrich

(56) Entgegenhaltungen:
- EP-A2- 1 320 121
- US-A1- 2011 297 329

## Beschreibung

Die Erfindung gemäss dem unabhängigen Anspruch 1 betrifft ein Verfahren zur Übergabe eines gedünnten, insbesondere geschliffenen, Halbleiterwafers von einem ersten Halter zu einem zweiten Halter, bei dem der erste Halter mithilfe einer von Unterdruck bewirkten Flächenkraft den Halbleiterwafer plan hält und zu dessen Übergabe an den zweiten Halter unter Verringerung seiner bewirkten Flächenkraft loslässt und bei dem der zweite den Halbleiterwafer übernehmende Halter diesen mithilfe einer von Unterdruck bewirkten Flächenkraft weiter plan hält.

Gedünnte Halbleiterwafer bzw. im Speziellen ultradünne Halbleiterwafer sind aufgrund ihrer folienartigen Beschaffenheit meist gewölbt und daher besonders schwierig zu handhaben. Aus dem Stand der Technik sind daher Halter für gedünnte Halbleiterwafer bekannt (EP0565278A1), die auch gebogene und verformte Halbleiterwafer ohne Trägersubstrat aufnehmen und transportieren können. Weiters sind Systeme zur Übergabe eines Halbleiterwafers bekannt (US6435809B2). Bei diesem System wird der Halbleiterwafer mit Hilfe von Unterdruck von einem ersten Halter zu einem zweiten Halter transportiert. Ist die Position über dem zweiten Halter erreicht, wird der vom Bernoulli-Effekt erzeugte Unterdruck abgeschaltet und der Halbleiterwafer an den zweiten Halter übergeben. Nachteilig bei dieser Art der Übergabe ist, dass sie für gedünnte Halbleiterwafer nicht geeignet ist. Problematisch ist insbesondere, dass, sobald der erste Halter den Halbleiterwafer freigibt, dieser wieder seine ursprüngliche nicht plane Form einnimmt. Diese Rückformung kann schlagartig erfolgen, wodurch der Halbleiterwafer mechanischem Stress ausgesetzt wird. Die daraus folgende Beanspruchung kann sogar bis zur Zerstörung des Halbleiterwafers führen. Es wird ebenso Bezug genommen auf den folgenden Stand der Technik: EP1320121 und US20110297329.

Der Erfindung liegt somit die Aufgabe zugrunde, ausgehend vom eingangs geschilderten Stand der Technik, ein Verfahren zu schaffen, bei dem auch gedünnte Halbleiterwafer ohne Zutun eines Operators einfach und sicher übergeben werden können.

Die Erfindung löst die gestellte Aufgabe dadurch, dass bei der Übergabe des Halbleiterwafers beide Halter auf gegenüberliegenden Flächen des Halbleiterwafers je eine Flächenkraft mit Hilfe von Unterdruck gleichzeitig bewirken, wobei zum Loslassen des Halbleiterwafers der erste Halter seine bewirkte Flächenkraft erst dann reduziert, wenn die vom zweiten Halter bewirkte Flächenkraft für ein planes Halten des Halbleiterwafers am zweiten Halter ausreicht.

Bewirken bei der Übergabe des Halbleiterwafers beide Halter auf gegenüberliegenden Flächen des Halbleiterwafers je eine Flächenkraft mit Hilfe von Unterdruck gleichzeitig, wobei zum Loslassen des Halbleiterwafers der erste Halter seine bewirkte Flächenkraft erst dann reduziert, wenn die vom zweiten Halter bewirkte Flächenkraft für ein planes Halten des Halbleiterwafers am zweiten Halter ausreicht, kann der Halbleiterwafer vorteilhaft während der gesamten Übergabe plan gehalten werden. Dies ist auch insofern von Bedeutung, weil gerade gedünnte Halbleiterwafer wegen ihrer folienartigen Beschaffenheit gewölbte Formen einnehmen können. Wirken aber erfindungsgemäß während der Übergabe Flächenkräfte von beiden Haltern gleichzeitig, so kann das verhindert werden. Wird weiters die vom ersten Halter bewirkte Flächenkraft bis zum ausreichenden Aufbau der Flächenkraft am zweiten Halter aufrechterhalten, kann der Halbleiterwafer während jedes Zeitpunkts der Übergabe plan gehalten werden. Damit kann mechanischer Stress auf den Halbleiterwafer, verursacht durch das Zurückspringen in seine gewölbte Ausgangsform, verhindert werden.

Werden die während der Übergabe auf beide gegenüberliegende Flächen des Halbleiterwafers einwirkenden Flächenkräfte aneinander angeglichen, kann eine besonders schonende Übergabe des Halbleiterwafers vom ersten zum zweiten Halter erfolgen. Dies kann besonders bei einem gedünnten Halbleiterwafer mit folienartiger Beschaffenheit von Vorteil sein.

Wird die vom zweiten Halter auf den Halbleiterwafer bewirkte Flächenkraft vor dem Reduzieren der vom ersten Halter bewirkten Flächenkraft bestimmt, kann die Sicherheit in einer planen Übergabe des Halbleiterwafers erhöht werden. Insbesondere kann eine Übergabe erst dann zugelassen werden, wenn die Flächenkraft zum planen Halten des Halbleiterwafers ausreicht.

Eine Vereinfachung beim Bestimmen der Flächenkraft des zweiten Halters kann sich ergeben, wenn in Abhängigkeit von mindestens einer bei der Übergabe detektierten Druckschwankung am ersten Halter auf die vom zweiten Halter auf den Halbleiterwafer bewirkte Flächenkraft rückgeschlossen wird. Eine Druckschwankung am ersten Halter kann nämlich auf den Fortschritt im Aufbau der Flächenkraft vom zweiten Halter hinweisen, insbesondere kann damit erkannt werden, ob die Flächenkraft des zweiten Halters bereist ausreichend hoch ist, eine plane Übergabe des Halbleiterwafers zu garantieren. Denkbar ist, dass erst auf Basis der so rückgeschlossenen Flächenkraft des zweiten Halters ein Loslassen des Halbleiterwafers vom ersten Halter zugelassen wird, was zudem eine zügige Übergabe zwischen den Haltern erlauben kann.

Vorteile können sich ergeben, wenn über mindestens einen am jeweiligen Halter vorgesehenen Sensor die Lage und/oder Position des Halbleiterwafers am jeweiligen Halter überwacht wird. Zudem kann damit die Präsenz des Halbleiterwafers vergleichsweise einfach und vor allem auch berührungslos bestimmt werden, womit auch eine erfolgreiche Übergabe vom ersten auf den zweiten Halter festgestellt werden kann.

Im Hinblick auf die Anforderungen zum sicheren und beschädigungsfreien Halten des Halbleiterwafers kann sich ein kapazitiver Sensor besonders zur Überwachung der Lage und/oder Position des Halbleiterwafers am jeweiligen Halter auszeichnen.

Es ist jedoch auch im Rahmen der Erfindung denkbar, gemeinsam oder anstatt eines oder mehrerer kapazitiver Sensoren taktile Sensoren zu verwenden. Auf diese Weise kann ermöglicht werden, das Verfahren besonders gut auf die individuellen Erfordernisse und Gegebenheiten einzustellen.

Wird über mindestens einen am jeweiligen Halter vorgesehenen Sensor der Unterdruck zwischen dem jeweiligen Halter und dem Halbleiterwafer überwacht, können deren Messdaten für eine Optimierung des Übergabeablaufs genutzt werden. Diese Sensoren können auch zur Messung von Druckschwankungen dienen, aus denen wiederum auf die im zweiten Halter auf den Halbleiterwafer bewirkte Flächenkraft rückgeschlossen werden kann. Auf diese Weise kann es also möglich werden, ein besonders sicheres Verfahren zur Verfügung zu stellen, das zugleich einen lediglich geringen konstruktiven Aufwand erfordert.

Ein Unterdrucksensor als Sensor zur Messung von Druckschwankungen kann sich bei der Integration in einen Halter, der Gasführungen zur Erzeugung eines Unterdrucks aufweist, besonders eignen. Zudem kann damit ein standfestes Verfahren ermöglicht werden.

Zur weiteren Verbesserung des Verfahrens kann vorgesehen sein, dass der Unterdruck zwischen dem jeweiligen Halter und dem Halbleiterwafer über am jeweiligen Halter vorgesehene Vakuumdüsen und/oder Bernoullidüsen erzeugt wird. Im Gegensatz zu Vakuumdüsen können Bernoullidüsen den Halbleiterwafer berührungslos halten, wodurch die Gefahr der Beschädigung des Halbleiterwafers minimiert werden kann. Vakuumdüsen können dazu beitragen, dass auch stärker gewölbte Halbleiterwafer plan gehalten werden.

Anhand der Figuren ist beispielsweise das erfindungsgemäße Verfahren anhand einer Ausführungsvariante näher dargestellt. Es zeigen
- Fig. 1: eine Schnittansicht des ersten Halters beim Aufnehmen des Halbleiterwafers,
- Fig. 2: eine Schnittansicht beider Halter zu Beginn der Übergabe des Halbleiterwafers,
- Fig. 3: eine Schnittansicht beider Halter während der Übergabe des Halbleiterwafers und
- Fig. 4: eine Schnittansicht des zweiten Halters nach der Übergabe des Halbleiterwafers

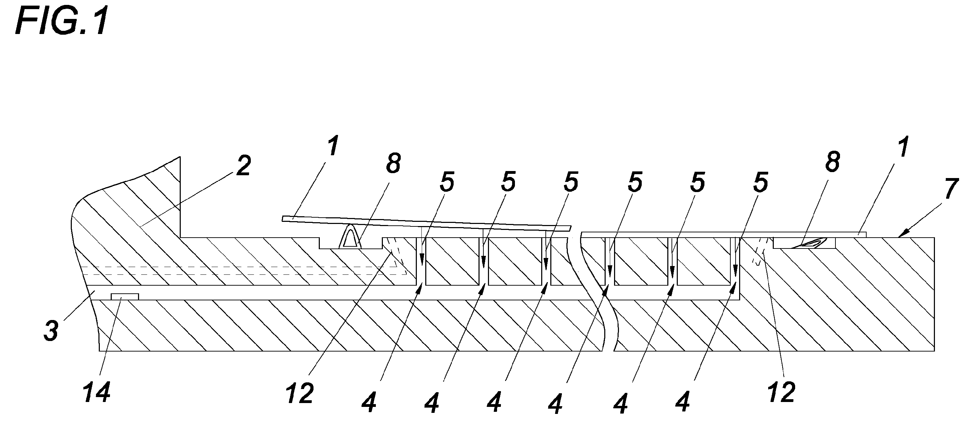

Gemäß Fig. 1 wird beispielsweise der gedünnte -oftmals als ultradünn bezeichnete-Halbleiterwafer 1 vom ersten Halter 2 aufgenommen. Die über die Unterdruckzuleitung 3 angeschlossenen Vakuumdüsen 4 erzeugen einen Unterdruck, der eine anziehende Flächenkraft 5 auf den Halbleiterwafer 1 bewirkt. Im linken Teil der Fig. 1 ist die gewölbte Ursprungsform des Halbleiterwafers 1, der noch nicht vollständig an den Halter 2 herangezogen ist, sondern auf der flexiblen Dichtung 8 aufliegt, noch erkennbar. Im rechten Teil von Fig. 1 hingegen ist der gedünnte Halbleiterwafer 1 schon vollständig plan an den Halter 2 angezogen. Dabei liegt der Halbleiterwafer 1 an der Auflage 7 auf - die flexible Dichtung 8 wird bereits gequetscht.

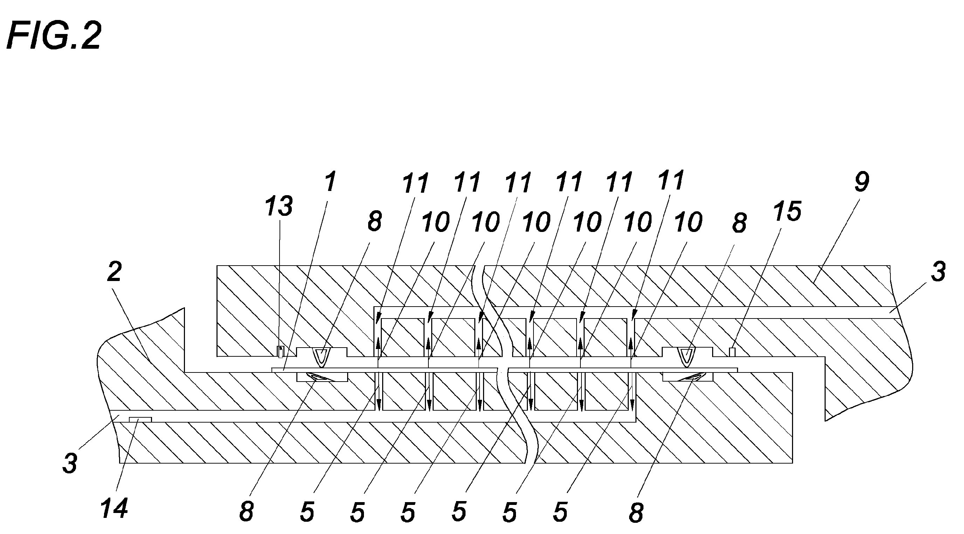

In einem darauffolgenden Schritt wird nun, wie in Fig. 2 beispielhaft gezeigt, der zweite Halter 9 herangeführt, wobei der gedünnte Halbleiterwafer 1 bereits ganzflächig plan am ersten Halter 2 anliegend gehalten ist - wobei Letzteres nicht zwingend ist. So ist ebenso ein planes aber berührungsloses Halten des Waferrahmens mithilfe eines durch den Bernoulli-Effekt verursachten hydrodynamischen Unterdrucks ebenso vorstellbar. Im Allgemeinen wird dazu weiter erwähnt, dass die vom jeweiligen Unterdruck bewirkte Flächenkraft 5, 10 entweder von Vakuumdüsen 4, 11 und/oder von Bernoullidüsen 12 erzeugt werden kann, wie diese Bernoullidüsen 12 beispielsweise in Fig. 1 am ersten Halter 2 strichliert dargestellt sind.

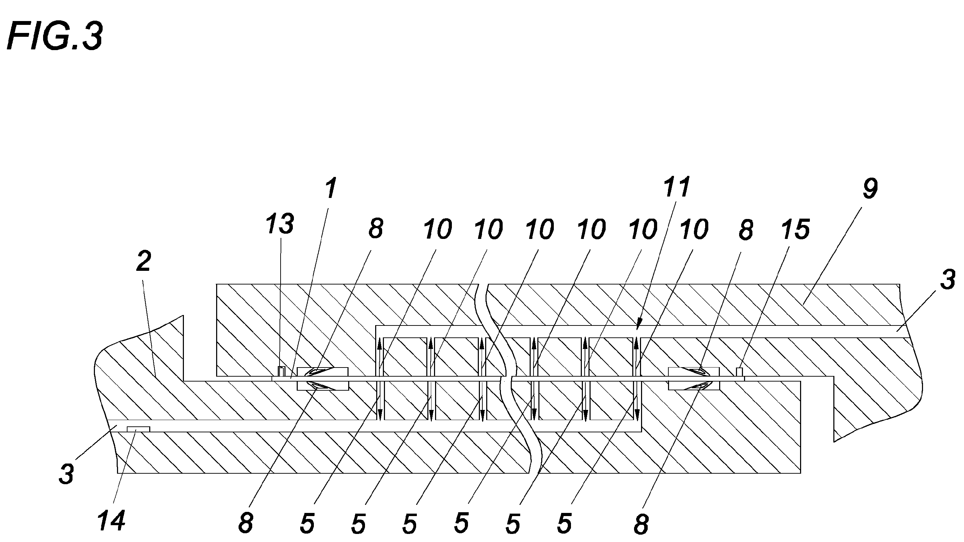

Der zweite Halter 9 beginnt nun auf den gedünnten planen Halbleiterwafer 1 mit einer Flächenkraft 10 einzuwirken. Währenddessen wird der Halbleiterwafer 1 stets plan vom ersten Halter 2 gehalten, wie dies nach den Figuren 2 und 3 erkannt werden kann. Es tritt daher eine Situation bei der Übergabe des Halbleiterwafers (1) auf, bei dem beide Halter 2, 9 auf gegenüberliegenden Flächen des Halbleiterwafers 1 je eine Flächenkraft 5, 10 mit Hilfe von Unterdruck gleichzeitig bewirkten.

In der Lage des zweiten Halters 9 gegenüber dem ersten Halter 2 gemäß Fig. 3 wird vom zweiten Halter 9 solch eine Flächenkraft 10 auf den gedünnten Halbleiterwafer 1 ausgeübt, die ausreicht, den Halbleiterwafer 1 ebenso plan am zweiten Halter 9 zu halten. Erfindungsgemäß wird zu diesem Zeitpunkt der Halbleiterwafer 1 sowohl vom Halter 2 als auch vom Halter 9 plan gehalten.

Zudem wird durch einen Sensor, insbesondere einen kapazitiven Sensor 15 oder einen taktiler Sensor 13, die Präsenz des Halbleiterwafers 1 am zweiten Halter 9 erkannt bzw. überwacht. Vorstellbar ist, dies auch anhand eines Sensors 14, vorzugsweise eines Unterdrucksensors, vorzunehmen, wie dieser in den Figuren zum zweiten Halter 9 jedoch nicht näher dargestellt worden ist. Des Weiteren kann es sich als hilfreich erweisen, zusätzlich oder anstatt eines oder mehrerer kapazitiver Sensoren taktile Sensoren, etwa tastende oder Kraft-Momenten-Sensoren einzusetzen, um das Verfahren hinsichtlich der gegebenen Erfordernisse besonders gut abzustimmen.

Der nach den Figuren 1 bis 3 dargestellte Unterdrucksensor 14 des ersten Halters 2 dienen dazu, Druckschwankungen des plan gehaltenen Halbleiterwafers 1 zu erkennen. Diese Druckschwankungen können nämlich auf den Aufbau der Flächenkraft 10 des zweiten Halters 9 zurückgehen, wodurch auch auf die Höhe der vom zweiten Halter 9 auf den Halbleiterwafer 1 bewirkten Flächenkraft 10 rückgeschlossen werden kann. Nähert bzw. gleicht sich die so ermittelte Flächenkraft 10 des zweiten Halters 9 der Flächenkraft 5 des ersten Halters 2 an, kann das Loslassen des Halbleiterwafers 1 vom ersten Halter 2 zugelassen werden, indem der erste Halter 2 seine bewirkte Flächenkraft 5 reduziert. In diesem Zusammenhang kann nämlich angenommen werden, dass die vom zweiten Halter 9 bewirkte Flächenkraft 10 für ein planes Halten des Halbleiterwafers 1 am zweiten Halter 9 ausreichend hoch ist. Im Allgemeinen ist jedoch auch vorstellbar, dass von beiden Haltern 2 und 9 die notwendige Höhe an Unterdruck bekannt ist, um den Halbleiterwafer 1 plan am jeweiligen Halter 2 bzw. 9 zu halten, sodass nach einem Erreichen des notwendigen Unterdrucks am zweiten Halter 9 mit dem Loslassen des ersten Halters 2 begonnen wird, um den Halbleiterwafer 1 zu übergeben. Hierzu sei angemerkt, dass die Höhe der Flächenkräfte 5, 10 für ein planes Halten des Halbleiterwafers 1 am jeweiligen Halter 2, 9 gleich aber auch unterschiedlich (Höhe der Flächenkräfte 5 > Höhe der Flächenkräfte 10 bzw. Höhe der Flächenkräfte 5 < Höhe der Flächenkräfte 10) sein können.

Daraufhin wird der Unterdruck am ersten Halter 2 abgebaut und somit der Halbleiterwafer 1 vom ersten Halter 2 losgelassen. Da der zweite übernehmende Halter 9 den Halbleiterwafer 1 bereits plan hält, kann dieser nicht in seine gewölbte Ursprungsform zurückspringen. Dementsprechend werden mechanischer Stress und eventuell damit verbundene Beschädigungen des Halbleiterwafers 1 vermieden.

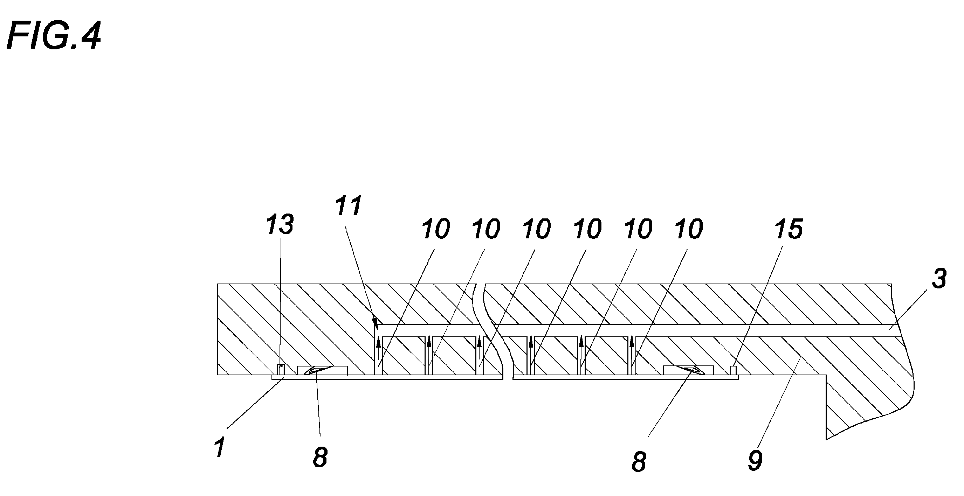

Figur 4 zeigt den zweiten Halter 9, der den Halbleiterwafer 1 plan mit der vom Unterdruck bewirkten Flächenkraft 10 nach der erfindungsgemäßen Übergabe hält.

Im Allgemeinen wird festgehalten, dass es sich bei den beiden Haltern 2, 9 um Endeffektoren, Bearbeitungs/Inspektions-Chucks oder andere Halter zum Handling eines Halbleiterwafers 1 handel kann.

## Patentansprüche

1. Verfahren zur Übergabe eines gedünnten, insbesondere geschliffenen, Halbleiterwafers (1) von einem ersten Halter (2) zu einem zweiten Halter (9), bei dem der erste Halter (2) mithilfe einer von Unterdruck bewirkten Flächenkraft (5) den Halbleiterwafer (1) plan hält und zu dessen Übergabe an den zweiten Halter (9) unter Verringerung seiner bewirkten Flächenkraft (5) loslässt und bei dem der zweite den Halbleiterwafer (1) übernehmende Halter (9) diesen mithilfe einer von Unterdruck bewirkten Flächenkraft (10) weiter plan hält, wobei bei der Übergabe des Halbleiterwafers (1) beide Halter (2, 9) auf gegenüberliegenden Flächen des Halbleiterwafers (1) je eine Flächenkraft (5, 10) mit Hilfe von Unterdruck gleichzeitig bewirken, wobei zum Loslassen des Halbleiterwafers (1) der erste Halter (2) seine bewirkte Flächenkraft (5) erst dann reduziert, wenn die vom zweiten Halter (9) bewirkte Flächenkraft (10) für ein planes Halten des Halbleiterwafers (1) am zweiten Halter (9) ausreicht, die vom zweiten Halter (9) auf den Halbleiterwafer (1) bewirkte Flächenkraft (10) vor dem Reduzieren der vom ersten Halter (2) bewirkten Flächenkraft (5) bestimmt wird, dadurch gekennzeichent, dass in Abhängigkeit von
mindestens einer bei der Übergabe detektierten Druckschwankung am ersten Halter (2) auf die vom zweiten Halter (9) auf den Halbleiterwafer (1) bewirkte Flächenkraft (10) rückgeschlossen wird.

2. Verfahren nach Anspruch 1, **dadurch gekennzeichnet, dass** die während der Übergabe auf beide gegenüberliegende Flächen des Halbleiterwafers (1) einwirkenden Flächenkräfte (5, 10) aneinander angeglichen werden.

3. Verfahren nach einem der Ansprüche 1 bis 2, **dadurch gekennzeichnet, dass** über mindestens einen am jeweiligen Halter (2, 9) vorgesehenen Sensor (13, 15) die Lage und/oder Position des Halbleiterwafers (1) am jeweiligen Halter (2, 9) überwacht wird.

4. Verfahren nach Anspruch 3, **dadurch gekennzeichnet, dass** als Sensor ein kapazitiver Sensor (15) und/oder ein taktiler Sensor (13) verwendet wird.

5. Verfahren nach einem der Ansprüche 1 bis 4, **dadurch gekennzeichnet, dass** über mindestens einen am jeweiligen Halter (2, 9) vorgesehenen Sensor (14) der Unterdruck zwischen dem jeweiligen Halter (2, 9) und dem Halbleiterwafer (1) überwacht wird.

6. Verfahren nach Anspruch 5, **dadurch gekennzeichnet, dass** als Sensor (14) ein Unterdrucksensor verwendet wird.

7. Verfahren nach einem der Ansprüche 1 bis 6, **dadurch gekennzeichnet, dass** der Unterdruck zwischen dem jeweiligen Halter (2, 9) und dem Halbleiterwafer (1) über am jeweiligen Halter (2, 9) vorgesehene Vakuumdüsen (4, 11) und/oder Bernoullidüsen (12) erzeugt wird.

## Claims

1. A method for transferring a thinned, more particularly ground, semiconductor wafer (1) from a first support (2) to a second support (9), in which the first support (2) holds the semiconductor wafer (1) in a planar manner by means of a surface force (5) produced by a vacuum and releases said wafer for its transfer to the second support (9) by reducing its produced surface force (5), and in which the second support (9) receiving the semiconductor wafer (1) continues to hold it in a planar manner by means of a surface force (10) produced by means of a vacuum, wherein, during the transfer of the semiconductor wafer (1), both supports (2, 9) simultaneously each produce a surface force (5, 10) by means of a vacuum on opposite surfaces of the semiconductor wafer (1), wherein for releasing the semiconductor wafer (1) the first support (2) reduces its produced surface force (5) only when the surface force (10) produced by the second support (9) is adequate for planar holding of the semiconductor wafer (1) on the second support (9), the surface force (10) produced by the second support (9) on the semiconductor wafer (1) is determined before the reduction of the surface force (5) produced by the first support (2), **characterized in that** conclusions are drawn on the surface force (10) produced by the second support (9) on the semiconductor wafer (1) depending on at least one pressure fluctuation on the first support (2) detected during the transfer.

2. A method according to claim 1, **characterized in that** the surface forces (5, 10) acting during the transfer on both opposite surfaces of the semiconductor wafer (1) are adjusted to each other.

3. A method according to one of the claims 1 to 2, **characterized in that** the location and/or position of the semiconductor wafer (1) on the respective support (2, 9) is monitored via at least one sensor (13, 15) which is provided on the respective support (2, 9).

4. A method according to claim 3, **characterized in that** a capacitive sensor (15) and/or a tactile sensor (13) is used as a sensor.

5. A method according to one of the claims 1 to 4, **characterized in that** the vacuum between the respective support (2, 9) and the semiconductor wafer (1) is monitored via at least one sensor (14) provided on the respective support (2, 9).

6. A method according to claim 5, **characterized in that** a vacuum sensor is used as a sensor (14).

7. A method according to one of the claims 1 to 6, **characterized in that** the vacuum between the respective support (2, 9) and the semiconductor wafer (1) is produced via vacuum nozzles (4, 11) and/or Bernoulli nozzles (12) that are provided on the respective support (2, 9).

## Revendications

1. Procédé pour transférer une plaquette de semi-conducteur (1) amincie, en particulier polie, d'un premier support (2) à un deuxième support (9), dans lequel le premier support (2) maintient la plaquette de semi-conducteur (1) à plat à l'aide d'une force de surface (5) exercée par une dépression et la relâche pour la transférer au deuxième support (9) en réduisant sa force de surface (5) qu'il exerce et dans lequel le deuxième support (9) recevant la plaquette de semi-conducteur (1) continue à maintenir celle-ci à plat à l'aide d'une force de surface (10) exercée par une dépression, les deux supports (2, 9) exerçant chacun simultanément une force de surface (5, 10) à l'aide d'une dépression sur des surfaces opposées de la plaquette de semi-conducteur (1) lors du transfert de la plaquette de semi-conducteur (1), le premier support (2) ne réduisant la force de surface (5) qu'il exerce pour relâcher la plaquette de semi-conducteur (1) que lorsque la force de surface (10) exercée par le deuxième support (9) est suffisante pour maintenir la plaquette de semi-conducteur (1) à plat sur le deuxième support, la force de surface (10) exercée par le deuxième support (9) sur la plaquette de semi-conducteur (1) étant déterminée avant la réduction de la force de surface (5) exercée par le premier support (2), **caractérisé en ce que** la force de surface (10) exercée par le deuxième support (9) sur la plaquette de semi-conducteur (1) est déduite en fonction d'au moins une variation de la pression détectée lors du transfert au niveau du premier support (2).

2. Procédé selon la revendication 1, **caractérisé en ce que** les forces de surface (5, 10) agissant sur les deux surfaces opposées de la plaquette de semi-conducteur (1) sont équilibrées l'une avec l'autre.

3. Procédé selon l'une des revendications 1 à 2, **caractérisé en ce qu'**au moins un capteur (13, 15) prévu sur chaque support (2, 9) correspondant surveille la position et/ou le placement de la plaquette de semi-conducteurs (1) sur le support (2, 9) correspondant.

4. Procédé selon la revendication 3, **caractérisé en ce que** le capteur utilisé est un capteur capacitif (15) et/ou un capteur tactile (13).

5. Procédé selon l'une des revendications 1 à 4, **caractérisé en ce qu'**au moins un capteur (14) prévu sur chaque support (2, 9) surveille la dépression entre le support (2, 9) correspondant et la plaquette de semi-conducteur (1).

6. Procédé selon la revendication 5, **caractérisé en ce que** le capteur (14) utilisé est un capteur de dépression.

7. Procédé selon l'une des revendications 1 à 6, **caractérisé en ce que** la dépression entre chaque support (2, 9) et la plaquette de semi-conducteur (1) est produite par des buses à vide (4, 11) et/ou des buses de Bernoulli (12) prévues sur le support (2, 9) correspondant.
